# EUROPÄISCHE PATENTSCHRIFT

(11) **EP 1 105 344 B1**
(45) Veröffentlichungstag und Bekanntmachung des Hinweises auf die Patenterteilung: **25.04.2012**
(21) Anmeldenummer: 99952247.7
(22) Anmeldetag: 03.08.1999
(51) Int. Cl.: B81B 3/00, B81C 1/00

(54) **MIKROMECHANISCHER SENSOR UND VERFAHREN ZU SEINER HERSTELLUNG**
MICROMECHANICAL SENSOR AND CORRESPONDING PRODUCTION METHOD
CAPTEUR MICROMECANIQUE ET SON PROCEDE DE PRODUCTION

(30) Priorität: 11.08.1998 DE 19836342
(43) Veröffentlichungstag der Anmeldung: 13.06.2001
(73) Patentinhaber: Infineon Technologies AG, 85579 Neubiberg (DE)
(72) Erfinder: AIGNER, Robert, D-81675 München (DE); BEVER, Thomas, D-81739 München (DE); TIMME, Hans-Jörg, D-85521 Ottobrunn (DE)
(74) Vertreter: Ginzel, Christian
(86) Internationale Anmeldenummer: PCT/DE1999/002375
(87) Internationale Veröffentlichungsnummer: WO 2000/009440

(56) Entgegenhaltungen:
- DE-C- 4 441 903
- DE-C- 19 648 424
- US-A- 5 110 373
- US-A- 5 259 247
- US-A- 5 725 785
- PATENT ABSTRACTS OF JAPAN vol. 012, no. 320 (E-651), 30. August 1988 (1988-08-30) -& JP 63 084072 A (AISIN SEIKI CO LTD), 14. April 1988 (1988-04-14)
- PATENT ABSTRACTS OF JAPAN vol. 012, no. 277 (E-640), 30. Juli 1988 (1988-07-30) -& JP 63 056962 A (FUJI ELECTRIC CO LTD), 11. März 1988 (1988-03-11)

## Beschreibung

Die Erfindung betrifft einen mikromechanischen Sensor umfassend ein Substrat, eine über die gesamte Substratoberfläche ragende epitaktisch aufgewachsene Schicht, eine Membran, eine Gegenelektrode, eine Rückseitenöffnung und einen Hohlraum, welcher zwischen Membran und Gegenelektrode angeordnet ist. Ferner wird ein Verfahren zur Herstellung des vorstehend beschriebenen mikromechanischen Sensors beschrieben.

Mikromechanische Sensoren sind in einer Reihe von Dokumenten beschrieben. So beschreibt beispielsweise das Dokument US 5,110,373 eine Verfahren zur Herstellung einer Siliziumembran, die in mikromechanischen Sensoren eingesetzt werden. Das Dokument JP 63084072 zeigt einen Drucksensor sowie ein Verfahren zu dessen Herstellung.

In Anwendungen, bei denen es auf geringe Kosten und möglichst geringen Platzbedarf ankommt, wie beispielsweise Drucksensoren, Mikrofone oder auch Beschleunigungesensoren, werden miniaturisierte mikromechanische Sensoren mit auf dem Chip integrierten Halbleiterschaltungselementen benötigt.

Ein mikromechanischer Sensor zur Anwendungen in der Akustik ist in der US 5,146,435 beschrieben. Der angegebene Sensor besteht aus einer beweglichen Membran und einer Stützstruktur aus einem Siliziumsubstrat. Oberhalb des Substrats ist eine Gegenelektrode aus Silizium angeordnet, die einen Hohlraum zwischen Membran und Gegenelektrode bildet. Die Gegenelektrode und die Membran ist durch geeignete Dotierung des Siliziums leitfähig ausgebildet, wodurch eine Kondensatorstruktur entsteht. Wird die Membran zu Schwingungen angeregt, verändert sich die Kapazität des Kondensators. Die Kapazitätsbestimmung erfolgt mit Hilfe von auf der Oberseite der Struktur angeordneten Metallkontakten. Eine Ausführungsform mit integrierter Ansteuer- bzw. Auswerteelektronik ist nicht angegeben.

Bei der angegebenen Sensorstruktur ragt die Gegenelektrode über die Substratoberfläche hinaus. Die Gegenelektrode befindet sich auf der Oberseite des Sensors. Zum Zwecke einer Verbindung des Hohlraums mit der Umgebung sind in der Gegenelektrode Ventilationsöffnungen eingearbeitet. Unterhalb der Membran bran ist der Wafer mit einer Öffnung versehen, die ebenfalls eine Verbindung der Membranoberfläche mit der Umgebung herstellt. Durch die unterseitige Öffnung können an die Membran Schallschwingungen direkt herantreten und diese zu Schwingungen anregen.

Die deutsche Patentanmeldung 196 48 424.3 beschreibt einen mikromechanischen Sensor mit integriertem Schaltkreis, welcher bei Druck- und Schallmessungen eingesetzt werden kann. Der Sensor weist eine in Richtung der Oberseite angeordnete Membranfläche auf. Unterhalb der Membran befindet sich ein Hohlraum. Im Bereich des Substrats ist die Gegenelektrode angeordnet. Die Gegenelektrode weist Ventilationsöffnungen zur Reduzierung der Resonanzfrequenz der Membran auf. Die Ventilationsöffnungen sind in Richtung der Unterseite des Sensors angeordnet und verbinden das Volumen des Hohlraums mit der Unterseite des Sensors. Bei der Herstellung des beschriebenen mikromechanischen Sensors wird von einem SOI-Wafer (Silicon Oxide Isolator) ausgegangen. Ein SOI-Wafer besteht aus den Schichten einkristallines Silizum/Siliziumdioxid/einkristallines Silizium. Nach der Fertigstellung der Sensorstruktur auf der Oberseite des SOI-Wafers wird auf der Unterseite des Chips in einem zusätzlichen Ätzschritt ein Hohlraum hergestellt, welcher die Gegenelektrode mit den Ventilationsöffnungen freilegt. Die Ätzung dieser unterseitigen Öffnungen erfolgt selektiv gegenüber Siliziumoxid mit KOH oder TMAH. Gegenüber diesen Atzmitteln stellt die Siliziumoxidschicht des SOI-Substrats einen Ätzstopp dar.

Es wurde nun gefunden, daß bei der Herstellung von mikromechanischen Sensoren der Einsatz von KOH zur Rückseitenätzung Nachteile mit sich bringt. Es hat sich gezeigt, daß KOH während des Atzvorgangs bereits auf der Oberfläche des Sensors befindliche Strukturen angreifen kann, beispielsweise Schichten aus Aluminium auf der Oberseite des mikromechanischen Sensors, Werden mikromechanische Sensoren mit Membranen hergestellt, die zusätzliche Öffnungen aufweisen, ergeben sich besondere Probleme. Diese zusätzlichen öffnungen in der Membran werden entweder zur einfacheren Herstellung des Hohlraums oder zur Absenkung der Resonanzfrequenz hergestellt. Bei Ätzung der Rückseitenöffnungen kann es im Fertigungsablauf zu einer völligen Zerstörung von Teilbereichen der Membran kommen und damit zum Kontakt der Säure mit der Oberseite des mikromechanischen Sensors.

Aufgabe der vorliegenden Erfindung ist es, die vorstehend geschilderten Nachteile des Herstellungsverfahrens nach dem Stand der Technik zu vermeiden. Insbesondere soll durch Vermeidung dieser Nachteile die Wirtschaftlichkeit des Herstellungsverfahrens erhöht werden.

Diese Aufgabe wird erfindungsgemäß durch das in Patentanspruch 1 angegebene Verfahren und durch den Sensor gemäß Patentanspruch 4 gelöst.

Gemäß der Erfindung wird eine Ätzmethode zur Herstellung der Rückseitenöffnungen eingesetzt, welche durch eine Änderung der Ladungsträgerkonzentration im zu ätzenden Material während des Ätzvorgangs abgestoppt wird.

Vorteilhafte Ausführungsformen der Erfindung ergeben sich aus den Unteransprüchen.

Ein weiterer Gegenstand der Erfindung ist ein mikromechanischer Sensor umfassend ein Substrat 4, eine über die gesamte Substratoberfläche ragende epitaktisch aufgewachsene Schicht 1, eine aufseitig angeordnete Membran 5 aus überwiegend polykristallinem oder einkristallinem Silizium, eine unterhalb der Membran befindliche Gegenelektrode 7, eine Rückseitenöffnung 6 und einen Hohlraum 3 zwischen Membran und Gegenelektrode, welcher dadurch gekennzeichnet ist, daß der Wafer aus einem dotierten Halbleitermaterial besteht und die epitaktische Schicht zumindest in einem dem Substrat zugewandten Flächenbereich so dotiert ist, daß ein Sprung in der Ladungsträgerkonzentration an der Grenzfläche zwischen Substratmaterial (4) und epitaktischer Schicht (1) vorhanden ist.

Die Gegenelektrode 7 wird vorzugsweise durch einen in der epitaktischen Schicht angeordneten und durch Dotierung elektrisch leitfähig gemachten Bereich gebildet. Dieser Bereich befindet sich zweckmäßigerweise direkt unterhalb der Membran 5.

Die Erfindung betrifft auch die Verwendung der vorstehend beschriebenen mikromechanischen Sensoren in Drucksensoren und Mikrofonen.

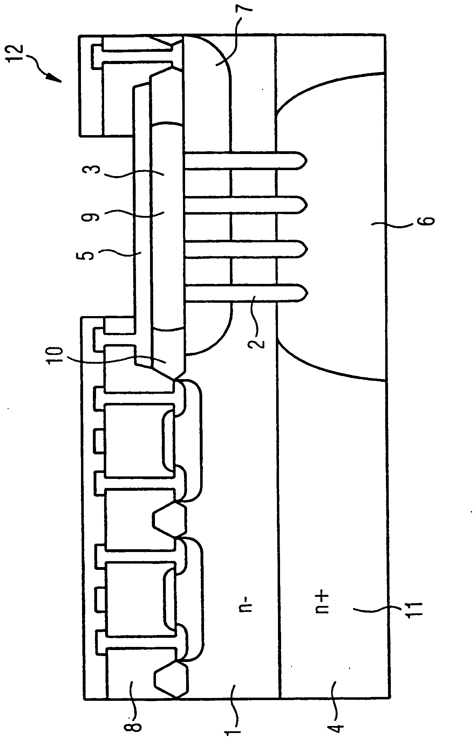

Figur 1 zeigt eine bevorzugte Ausführungsform für einen mikromechanischen Sensor gemäß der Erfindung.

Anhand des mikromechanischen Sensors in Figur 1 wird das Verfahren der Erfindung erläutert. Auf einem hochdotierten Substrat 4 mit einer Dotierungskonzentration von vorzugsweise mehr als 1 x 10¹⁸ cm⁻³ wird eine epitaktische Schicht 1 der Dicke 5 - 10 µm mit einer Dotierungskonzentration vorzugsweise im Bereich von 5 x 10¹⁴ cm⁻³ abgeschieden. Anschließend werden in zwei Schritten Öffnungen in den Wafer 4 geätzt. Im ersten Schritt erfolgt eine naßchemische Ätzung mit beispielsweise HF/HNO3 mit großer Ätzrate und im zweiten Schritt eine elektrochemische Ätzung mit Ätzstopp auf n⁻-Silizium (Epitaxieschicht). Wie sich zeigt, ist ein Schutz der auf der Oberseite des Sensors befindlichen Aluminiummetallisierung mit üblichen Fotoresist und Folie möglich. Bei der Herstellung des Sensors werden folgende Schritte durchgeführt:
Nach dem Aufbringen der Epitaxieschicht 1 werden Gräben 2 von der Oberseite in die Epitaxieschicht eingeätzt, welche bis in die Substratschicht 4 hineinreichen. Dann werden die Gräben mit Siliziumoxid auf an sich bekannte Weise gefüllt. Auf der Oberseite wird im Anschluß daran auf an sich bekannte Weise eine Halbleiterschaltung nach einem CMOS- oder BiCMOS-Prozeß aufgebracht. Es werden dabei auch der dotierte Bereich 7 und für die Herstellung der Abstandsschicht 10 benötigte Hilfsschichten aufgebracht. Auf der Oberseite der Hilfsschicht wird dann eine Siliziumschicht, welche polykristallin oder
einkristallin sein kann, aufgebracht. Die Dicke der Siliziumschicht ist vorzugsweise kleiner gleich 1 µm. Das Silizium für die Membranschicht 5 kann vorzugsweise in einem Prozeßschritt zusammen mit den Gate-Elektroden, die für MOSFET's vorgesehen sind, abgeschieden werden. Die elektronischen Bauelemente in der Bulk-Silizium-Schicht werden in herkömmlicher Weise hergestellt (VLSI-Prozeß oder CMOS-Prozeß). Ein Verfahren zur Herstellung dieser Strukturen auf Epitaxieschicht 1 ist beispielsweise in der deutschen Patentanmeldung 196 484 24.3 beschrieben.

Nach Fertigstellung der Oberseite des Chips wird die Unterseite bearbeitet. Zunächst wird zur Herstellung der Rückseitenöffnung 6 eine naßchemische Ätzung beispielsweise mit HF/HNO₃ oder auch KOH bzw. TMAH durchgeführt, welche den Vorteil einer hohen Ätzgeschwindigkeit hat. Dieser Ätzvorgang wird durch Zeitmessung abgestoppt. Im zweiten Schritt wird der Ätzvorgang für die Rückseitenöffnung 8 mit einer elektrochemischen Ätzung fortgesetzt. Während dieses Ätzvorgangs erfolgt ein Abstoppen der Rückseitenätzung an dem Übergang von hochdotiertem Substrat 4 zu niedrig dotierter Epitaxieschicht 1. Die elektrochemische Ätzung erfolgt mittels HF-Elektrolyt oder KOH-Elektrolyt.

Zur Fertigstellung des Sensors wird von der Rückseite her eine Ätzung z. B. mittels Flußsäure selektiv gegen Silizium durchgeführt. Hierdurch bildet sich der Hohlraum 3 und die Ventilationsöffnungen 2.

## Patentansprüche

1. Verfahren zur Herstellung eines mikromechanischen Sensors (12) umfassend die Schritte
a) Bereitstellung eines dotierten Halbleiterwafers (4),
b) Aufbringen einer epitaktischen Schicht (1), zumindest in einem dem Substrat zugewandten Flächenbereich die so dotiert ist, daß an der Grenzfläche (11) zwischen Halbleiterwafer und epitaktischer Schicht ein Sprung in der Ladungsträgerdichte auftritt,
c) Ätzen von Ventilationsöffnungen (2), die durch die epitaktische Schicht hindurchreichen, und Füllen der Ventilationsöffnungen mit einem Opfermaterial,
d) Aufbringen
- mindestens einer Opferschicht (9),
- mindestens einer Abstandsschicht (10),
- einer Membran (5), welche überwiegend aus polykristallinem oder einkristallinem Silizium besteht, und
- ggf. einer Halbleiterschaltung (8)
in an sich bekannter Technologie auf der Oberseite der Epitaxieschicht, wobei die Halbleiterschaltung nach Bildung der Membran oder während der Aufbringung der zur Bildung der Membran benötigten Schichten aufgebracht werden kann,
e) Ätzung einer rückseitig des Sensors angeordneten Öffnung (6), wobei die Ätzmethode so gewählt wird, daß der Ätzvorgang in Richtung der Oberseite voranschreitet und an der Grenzfläche zwischen Wafer (4) und Epitaxieschicht (1) durch Änderung der Ladungsträgerkonzentration abstoppt, und
f) Freilegen der Ventilationsöffnungen (2) und eines Hohlraums (3) durch Entfernung der/den Opferschicht/-en mit einem Ätzmittel,
so daß eine Membran (5), eine unterhalb der Membran befindliche Gegenelektrode (7) und ein Hohlraum (3) zwischen Membran und Gegenelektrode gebildet werden, wobei die Ventilationsöffnungen (2) den Hohlraum (3) mit der Rückseitenöffnung (6) verbinden.

2. Verfahren nach Anspruch 1,
**dadurch gekennzeichnet , , daß** die bei der Ätzung in Schritt e) ein elektrochemisches Ätzverfahren angewendet wird.

3. Verfahren nach mindestens einem der Ansprüche 1 oder 2,
**dadurch gekennzeichnet , , daß** die Rückseitenätzung in zwei Schritten erfolgt, wobei zunächst naßchemisch für eine definierte Zeitdauer bis nahe an die Grenzfläche zwischen Wafermaterial (4) und epitaktischer Schicht (1) herangeätzt wird, und im zweiten Schritt elektrochemisch geätzt wird, wobei der zweite Ätzvorgang durch Änderung der Ladungsträgerkonzentration zwischen Wafermaterial (4) und epitaktischer Schicht (1) gestoppt wird.

4. Mikromechanischer Sensor umfassend ein Substrat (4), eine über die gesamte Waferoberfläche ragende epitaktisch aufgewachsene Schicht (1), eine aufseitig angeordnete Membran (5) aus überwiegend polykristallinem oder einkristallinem Silizium, eine unterhalb der Membran befindliche Gegenelektrode (7), eine Rückseitenöffnung (6) und einen Hohlraum (3) zwischen Membran und Gegenelektrode,
**dadurch gekennzeichnet, daß** das Substrat aus einem dotierten Halbleitermaterial besteht und die epitaktische Schicht zumindest in einem dem Substrat zugewandten Flächenbereich so dotiert ist, daß ein Sprung in der Ladungsträgerkonzentration an der Grenzfläche zwischen Substratmaterial (4) und epitaktischer Schicht (1) vorhanden ist, und wobei in der Gegenelektrode Ventilationsöffnungen (2) vorhanden sind, welche den Hohlraum (3) mit der Rückseitenöffnung (6) verbinden.

5. Mikromechanischer Sensor nach Anspruch 4,
**dadurch gekennzeichnet, daß** das Substrat aus Silizium mit einer Ladungsträgerkonzentration im Bereich von mehr als 10¹⁸ cm⁻³ besteht.

6. Mikromechanischer Sensor nach Anspruch 4 oder 5,
**dadurch gekennzeichnet, daß** zumindest der dem Substrat zugewandte Flächenbereich der epitaktischen Schicht eine Ladungsträgerkonzentration von weniger als 5 x 10¹⁴ cm⁻³ hat.

7. Mikromechanischer Sensor nach mindestens einem der Ansprüche 4 bis 6,
**dadurch gekennzeichnet, daß** auf der Oberseite der epitaktischen Schicht (1) eine Halbleiterschaltung (8) in an sich bekannter Technologie aufgebracht ist.

8. Verwendung des mikromechanischen Sensors nach Anspruch 4 für Drucksensoren oder Mikrofone.

## Claims

1. Method of producing a micromechanical sensor (12), comprising the steps
a) providing a doped semiconductor wafer (4),
b) applying an epitaxial layer (1), at least in a portion of the area which faces the substrate, which is doped such that a jump in the charge carrier density occurs at the interface (11) between semiconductor wafer and epitaxial layer,
c) etching ventilation openings (2), which reach through the epitaxial layer, and filling the ventilation openings with a sacrificial material,
d) applying
- at least one sacrificial layer (9),
- at least one spacer layer (10),
- a membrane (5) which predominantly consists of polycrystalline or monocrystalline silicon,
- if appropriate, a semiconductor circuit (8)
to the top of the epitaxial layer, by using a technology known per se, wherein the semiconductor circuit can be applied after the formation of the membrane or during the application of the layers needed to form the membrane,
e) etching an opening (6) arranged on the rear of the sensor, the etching method being selected such that the etching process progresses in the direction of the top and stops at the interface between wafer (4) and epitaxial layer (1) by changing the charge carrier concentration, and
f) exposing the ventilation openings (2) and a cavity (3) by removing the sacrificial layer(s) with an etchant,
so that a membrane (5), a counterelectrode (7) located underneath the membrane, and a cavity (3) between membrane and counterelectrode are formed, the ventilation openings (2) connecting the cavity (3) to the rear opening (6).

2. Method according to Claim 1, **characterized in that**, in the etching in step e), an electrochemical etching process is used.

3. Method according to at least one of Claims 1 and 2, **characterized in that** etching the rear is carried out in two steps, firstly wet chemically for a defined time period until close to the interface between wafer material (4) and epitaxial layer (1), and electrochemically in the second step, the second etching process being stopped by changing the charge carrier concentration between wafer material (4) and epitaxial layer (1).

4. Micromechanical sensor comprising a substrate (4), an epitaxially grown layer (1) which projects over the entire wafer surface, a membrane (5) arranged on the top and made predominantly of polycrystalline or monocrystalline silicon, a counterelectrode (7) located underneath the membrane, a rear opening (6) and a cavity (3) between membrane and counterelectrode, **characterized in that** the substrate consists of a doped semiconductor material, and the epitaxial layer, at least in a portion of the area which faces the substrate, is doped such that there is a jump in the charge carrier concentration at the interface between substrate material (4) and epitaxial layer (1), and wherein in the counterelectrode there are ventilation openings (2) which connect the cavity (3) to the rear opening (6).

5. Micromechanical sensor according to Claim 4, **characterized in that** the substrate consists of silicon with a charge carrier concentration in the region of more than 10¹⁸ cm⁻³.

6. Micromechanical sensor according to Claim 4 or 5, **characterized in that** at least that portion of the area of the epitaxial layer which faces the substrate has a charge carrier concentration of less than 5 x 10¹⁴ cm⁻³.

7. Micromechanical sensor according to at least one of Claims 4 to 6, **characterized in that** a semiconductor circuit (8) is applied to the top of the epitaxial layer (1), using a technology known per se.

8. Use of the micromechanical sensor according to Claim 4 for pressure sensors or microphones.

## Revendications

1. Procédé de production d'un capteur (12) micromécanique comprenant les stades :
a) On se procure une tranche (4) semi-conductrice dopée,
b) On dépose une couche (1) épitaxiale au moins dans une zone de surface tournée vers le substrat, qui est dopée de façon à ce qu'il se produise à l'interface (11), entre la tranche semi-conductrice et la couche épitaxiale, un saut de la densité des porteurs de charge,
c) On ménage par attaque des ouvertures (2) de ventilation, qui traversent la couche épitaxiale et on remplit les ouvertures de ventilation par de la matière sacrificielle,
d) On dépose
- au moins une couche (9) sacrificielle,
- au moins une couche (10) intercalaire,
- une membrane (5) qui se compose en majorité de silicium polycristallin ou monocrystallin et
- le cas échéant un circuit (8) à semi-conducteur,
par une technologie en soi connue sur la face supérieure de la couche épitaxiale, le circuit à semi-conducteur pouvant être déposé après formation de la membrane pendant le dépôt de la couche nécessaire à la formation de la membrane,
e) On ménage par attaque une ouverture (6) disposée du côté arrière du capteur en choisissant le procédé d'attaque de façon à ce que l'opération d'attaque progresse dans la direction de la face supérieure et s'arrête par modification de la concentration de porteurs de charge à l'interface entre la tranche (4) et la couche (1) épitaxiale, et
f) On met à nu les ouvertures (2) de ventilation et une cavité (3) en enlevant la ou les couches sacrificielles par un moyen d'attaque,
de manière à former une membrane (5), une contre électrode (7) se trouvant en dessous de la membrane et une cavité (3) entre la membrane et la contre électrode, les ouvertures (2) de ventilation mettant la cavité (3) en communication avec l'ouverture (6) du côté arrière.

2. Procédé suivant la revendication 1,
**caractérisé en ce que** l'on utilise au stade e) pour l'attaque un procédé d'attaque électrochimique.

3. Procédé suivant au moins l'une des revendications 1 ou 2, **caractérisé en ce que** l'on effectue l'attaque de la face arrière en deux stades, en attaquant d'abord en voie chimique humide pendant un laps de temps défini jusqu'à proximité de l'interface entre le matériau (4) de la tranche et la couche (1) épitaxiale et, dans le deuxième stade, en attaquant par voie électrochimique, la deuxième opération d'attaque étant arrêtée entre le matériau (4) et la couche (1) épitaxiale par modification de la concentration de porteurs de charge.

4. Capteur micromécanique comprenant un substrat (4), une couche (1) que l'on a fait croître par épitaxie et qui dépasse de toute la surface de la tranche, une membrane (5) disposée sur le côté et en silicium d'une manière prépondérante polycristallin ou monocristallin, une contre électrode (7) de trouvant sur la membrane, une ouverture (6) du côté arrière et une cavité (3) entre la membrane et la contre électrode, **caractérisé en ce que** le substrat est en un matériau semi-conducteur dopé, la couche épitaxiale est au moins dans une zone de surface tournée vers le substrat et dopée de manière à ce qu'il y ait un saut de la concentration des porteurs de charge à l'interface entre le matériau (4) du substrat et la couche (1) épitaxiale et **en ce qu'**il y a, dans la contre électrode, des ouvertures (2) de ventilation qui mettent la cavité en communication avec l'ouverture (6) du côté arrière.

5. Capteur micromécanique suivant la revendication 4,
**caractérisé en ce que** le substrat est en silicium ayant une concentration de porteurs de charge de l'ordre de plus de 10¹⁸ cm⁻³.

6. Capteur micromécanique suivant la revendication 4 ou 5,
**caractérisé en ce que** la zone de surface de la couche épitaxiale, qui est tournée vers le substrat, a une concentration de porteurs de charge de moins de 5 x 10¹⁴ cm⁻³.

7. Capteur micromécanique suivant au moins l'une des revendications 4 à 6,
**caractérisé en ce que** sur la face supérieure de la couche (1) épitaxiale est déposé un circuit (8) à semi-conducteur par une technologie en soi connue.

8. Utilisation du capteur micromécanique suivant la revendication 4 pour des capteurs de pression ou pour des microphones.
